# EUROPEAN PATENT APPLICATION

(11) **EP 2 700 955 A2**
(43) Date of publication of application: **26.02.2014**
(21) Application number: 13181599.5
(22) Date of filing: 23.08.2013
(51) Int. Cl.: G01R 13/02

(54) **Trigger display**

(30) Priority: 23.08.2012 US 201213593275
(71) Applicant: Tektronix, Inc., Beaverton, Oregon 97077-0001 (US)
(72) Inventor: Sullivan, Steven K, Beaverton, OR Oregon 97006 (US); Veith, Kristie L, Beaverton, OR Oregon 97006 (US); Arnold, Shane L, Beaverton, OR Oregon 97006 (US)
(74) Representative: Brinck, David John Borchardt

(57) **Abstract**

Embodiments of the invention include an apparatus and method for displaying trigger frequency on a display of a test and measurement instrument. During each of a series of equal time intervals (605), a number of trigger events are counted (615). Each trigger event count is associated with a corresponding logical column of a trigger display window. The trigger event counts are written to memory locations associated with the corresponding logical columns of the trigger display window (620). Trigger frequency logic generates multiple trigger frequency indicators based on the trigger event counts. The trigger frequency indicators are displayed in the trigger display window (630) to quickly and efficiently convey trigger density information to a user of the test and measurement instrument. The apparatus includes jitter reduction logic to reduce or eliminate unwanted jitter related to the trigger frequency indicators.

## Description

### BACKGROUND

Embodiments of the present invention relate to a trigger display, and more particularly, to an apparatus and method for generating and displaying trigger frequency information on a display of a test and measurement instrument.

The principal use of a test and measurement instrument such as an oscilloscope is to observe how electrical signals vary over time. Typically, the oscilloscope shows electrical activity in a single window, although multiple windows can be used. The window often covers enough time so that some details, such as a few edges or pulses of the electrical signal, are visible. With a digital oscilloscope, the display may be updated rapidly as new signal activity is detected. However, it is often not clear to a user how often the activity is occurring. The display of the oscilloscope may show only a small fraction of all available time. With older analog oscilloscopes, the brightness of the display sometimes gave an indication of how often an event was occurring such that events that happened more often were drawn much brighter than events that happened rarely.

Some conventional oscilloscopes have a search feature that uses a software program to search through previously acquired data looking for search conditions. The search condition can be programmed to be the same as a trigger condition. For every condition that is found, a mark is placed in the window. Such approaches require significant processing resources and are therefore slow. When large numbers of trigger events are acquired, for example, such search approach is slower, even to the point of not being very practical. In addition, there is a finite amount of memory for search events. When there is a large number of search events, the memory quickly fills and the remaining search events are ignored. When multiple search events fall at the same location on the display (due to the finite resolution of the display), the conventional search has no way of indicating these multiple events to the user.

Accordingly, a need remains for an improved apparatus and method for efficiently determining and displaying trigger frequency information. Embodiments of the invention address these and other limitations in the prior art.

### BRIEF DESCRIPTION OF THE DRAWINGS

Figure 1A illustrates an example block diagram of a test and measurement instrument in accordance with some embodiments of the present invention.

Figure 1B illustrates a display of the test and measurement instrument of Figure 1A, including trigger indicators, according to some embodiments of the present invention.

Figure 2 illustrates an example of a trigger display window of the display of Figure 1B.

Figure 3 illustrates another example of a trigger display window of the display of Figure 1B.

Figure 4 illustrates yet another example of a trigger display window of the display of Figure 1B.

Figures 5A and 5B illustrate still another example of a trigger display window of the display of Figure 1B.

Figure 6 illustrates a flow diagram showing a technique for generating and displaying trigger frequency indicators in accordance with some embodiments of the present invention.

The foregoing and other features and advantages of the inventive concepts will become more readily apparent from the following detailed description of the example embodiments, which proceeds with reference to the accompanying drawings.

### DETAILED DESCRIPTION

Reference will now be made in detail to embodiments of the present invention, examples of which are illustrated in the accompanying drawings. In the following detailed description, numerous specific details are set forth to enable a thorough understanding of the inventive concepts. It should be understood, however, that persons having ordinary skill in the art may practice the inventive concepts without these specific details. In other instances, well-known methods, procedures, components, circuits, and networks have not been described in detail so as not to unnecessarily obscure aspects of the embodiments.

It will be understood that, although the terms first, second, etc. may be used herein to describe various elements, these elements should not be limited by these terms. These terms are only used to distinguish one element from another. For example, a first indicator could be termed a second indicator, and, similarly, a second indicator could be termed a first indicator, without departing from the scope of the inventive concept.

The terminology used in the description of the various embodiments herein is for the purpose of describing particular embodiments only and is not intended to be limiting of the inventive concepts. As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. The components and features of the drawings are not necessarily drawn to scale.

Embodiments of the present invention provides a new tool to users of test and measurement instruments for observing how often trigger events are happening. Users can quickly determine and analyze the frequency (i.e., density) of trigger events occurring within certain time intervals. The frequency and other characteristics of the input waveform directly affect the frequency or density of trigger events. In other words, trigger density is based at least in part on the input signal frequency or other characteristics of the input waveform. Trigger frequency indicators are displayed and differentiated between different frequency ranges by using different colors or physical dimensions of the trigger frequency indicators. Visible jitter that can otherwise be present in connection with the display of the trigger frequency indicators can be reduced or eliminated using jitter reduction logic. These and other inventive aspects are described in detail below.

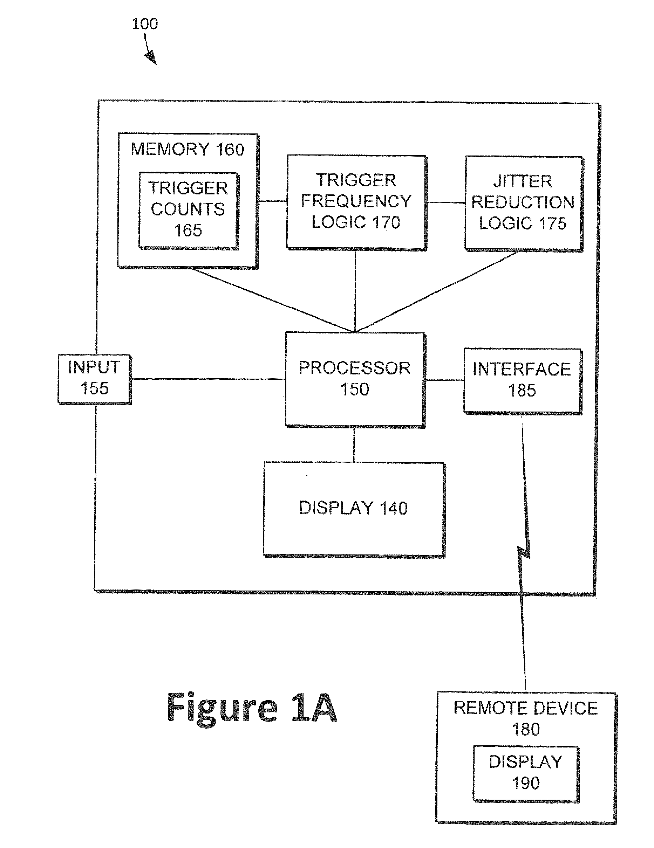

Figure 1A illustrates an example block diagram of a test and measurement instrument 100 in accordance with some embodiments of the present invention. The test and measurement instrument 100 can be an oscilloscope, a logic analyzer, a spectrum analyzer, a network analyzer, or the like. Generally, for the sake of consistency and explanation, the test and measurement instrument 100 is referred to herein as an oscilloscope.

The oscilloscope 100 can include an input 155. The input 155 can include one or more terminals for receiving one or more electrical signals under test. The input 155 can be coupled to a processor 150. The processor 150 can include any suitable micro-processor. The processor 150 can be coupled to memory 160. The memory 160 can be any variety of memory. For example, the memory 160 can be dynamic memory, static memory, read-only memory, random-access memory, or the like. The memory 160 can store trigger counts, or other related values associated with trigger counts, as explained in detail below.

The processor 150 can be associated with trigger frequency logic 170 and/or jitter reduction logic 175. The trigger frequency logic 170 and the jitter reduction logic 175 can include software code, firmware, an application specific integrated circuit (ASIC), a field programmable gate array (FPGA), a hardware circuit, or any suitable combination thereof.

The trigger frequency logic 170 can generate a count of a number of trigger events occurring for each of a series of equal time intervals. The trigger event counts 165 can be stored in memory locations of the memory 160. The memory locations of the memory 160 are each associated with a corresponding one of the equal time intervals. Based on the trigger event counts 165, the trigger frequency logic 170 can generate trigger frequency indicators, which can be displayed by the display 140, as further described in detail below. While the display 140 is generally referred to herein as the display on which the trigger frequency indicators and other trigger and waveform information is presented, it will be understood that such trigger indicators and waveform information can be transmitted via interface 185 to a remote device 180 and displayed on a remote display 190 associated with the remote device 180. The remote device 180 can be, for example, a desktop computer, a laptop computer, a tablet, a smart phone, or the like.

The jitter reduction logic 175 can compensate for jitter that is caused when a trigger frequency indicator may be associated with more than one logical column of a display window. As further described below, the jitter reduction logic 175 can generate a double-wide trigger frequency indicator, thereby reducing or eliminating visible jitter on the display.

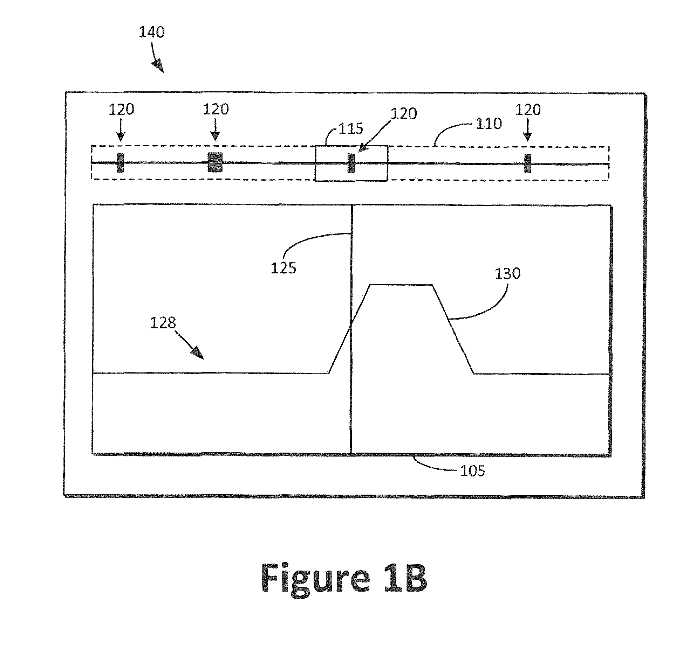

Figure 1B illustrates the display 140 of the oscilloscope 100 of Figure 1A, including trigger indicators 120, according to some embodiments of the present invention. The display 140 can include multiple windows. For example, the display 140 can include a main waveform window 105 and a trigger display window 110. The trigger display window 110 is preferably situated above the main waveform window 105 but it will be understood that it can be located anywhere within the display 140. The trigger display window 110 can function like a scroll bar. The trigger display window 110 covers significantly more time than the main waveform window 105.

The locations of trigger events are drawn in the trigger display window 110. For example, the locations of trigger events can be indicated by the trigger indicators 120. The trigger indicators 120 allow the operator of the oscilloscope to estimate how often trigger events are occurring and to see the pattern of trigger events.

The trigger display window 110 can also include a representative window 115. The representative window 115 represents a position in time of the main waveform window 105 relative to the trigger display window 110. Generally, the trigger display window 110 represents a fixed amount of total captured time. In contrast, the main waveform window 105 can be adjusted to cover more time or less time depending on the desires of the user. The representative window 115 can change in size proportionally with any change in coverage of the main waveform window 105.

As shown in the main waveform window 105 of Figure 1B, there is a single waveform 128 having a pulse 130. In this example, the trigger mode or criteria is to trigger on the rising edges of the electrical signal, as indicated by the main trigger event 125. In the representative window 115, a trigger indicator 120 indicates the presence of the trigger event associated with the waveform pulse 130. From the trigger display window 110, it can be seen that at least three other potential edge trigger events were found as indicated by the other three trigger indicators 120. Each trigger indicator 120 can represent a single trigger event or multiple trigger events. In the case of a single trigger event, the trigger indicator 120 may be a single tick mark. In the case of multiple trigger events, the trigger indicator 120 can appear wider because it is made of multiple tick marks. However, simply making the trigger indicator 120 to appear wider does not convey sufficient information about the actual density of the trigger events because of the limited resolution of the display. In accordance with some embodiments of the present invention, the density of the trigger events can be indicated by changing the color of the trigger indicator marks 120, by making the trigger indicator marks 120 larger or smaller, and/or by changing other physical dimensions of the trigger indicator marks 120, as further described in detail below.

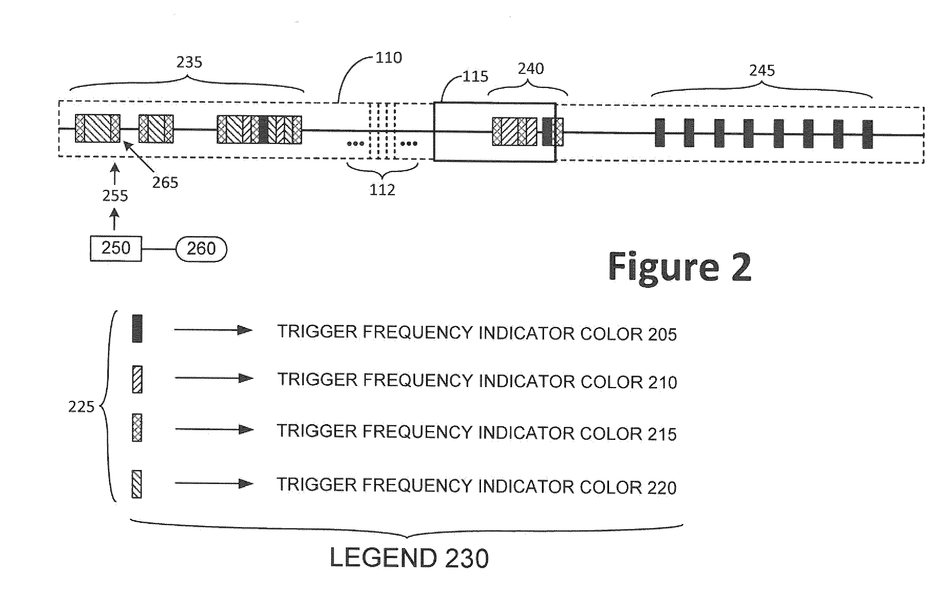

Figure 2 illustrates an example of a trigger display window 110 of the display 140 of Figure 1B. Color can be used to indicate the trigger density. The trigger density can be expressed as frequency and a color assigned to different frequency ranges. The time associated with the trigger display window 110 can be divided into equal time intervals 112. The processor 150 (of Figure 1A) can associate each of the time intervals 112 with a corresponding logical column of the trigger display window 110. During each of the time intervals 112, the trigger frequency logic 170 (of Figure 1A) can count a number of trigger events. In other words, the trigger frequency logic 170 can generate trigger event counts (165 of Figure 1A) based on the count of the number of trigger events for each of the individual time intervals 112. The processor 150 can receive the counts of the number of trigger events for each of the individual time intervals 112 from the trigger frequency logic 170, and can transmit the counts to the memory 160 for storage therein.

The memory 160 can store each count or related value to a memory location associated with a corresponding logical column from among the logical columns of the trigger display window 110. The memory 160 is about as deep as the number of total logical columns in the trigger display window 110. The trigger frequency logic 170 can generate trigger frequency indicators 225, as shown in legend 230, based on the trigger event counts 165 stored in the memory 160. The display 140 can display, within the trigger display window 110, the different trigger frequency indicators 225. Each of the trigger frequency indicators 225 represents density information of trigger events occurring within at least one of the time intervals 112. The amount of trigger information recorded is therefore decoupled from the amount of memory 160 available. In other words, assuming for the sake of explanation there are 100,000 potential trigger events but only 1000 logical columns of the trigger display window 110, the trigger information for all 100,000 potential trigger events need not be stored in the memory 160. Rather, the trigger event counts 165 function as consolidated information, i.e., stored in the form of counts associated with the 1000 logical columns, rather than being stored in the form of 100,000 individual trigger events, which may be impractical given the finite size of the memory.

In some embodiments, the trigger frequency indicators 225 convey the density information to an operator of the oscilloscope 100 using different colors of the trigger frequency indicators 225. In other words, given the certain amount of time represented in the trigger display window 110, trigger density may be expressed as or otherwise converted to frequency.

For example, the trigger frequency indicators 225 can include one or more indicators having a first color 205 (e.g., black) associated with a first trigger frequency range (e.g., from 0 to 300 KHz). By way of another example, the trigger frequency indicators 225 can include one or more indicators having a second color 210 (e.g., red) associated with another trigger frequency range (e.g., from 300 KHz to 1MHz). By way of yet another example, the trigger frequency indicators 225 can include one or more indicators having a third color 215 (e.g., orange) associated with yet another trigger frequency range (e.g., from 1MHz to 3MHz). By way of still another example, the trigger frequency indicators 225 can include one or more indicators having a fourth color 220 (e.g., yellow) associated with still another trigger frequency range (e.g., from 3MHz to 10Mhz or greater).

It will be understood that any suitable colors can be used. It will also be understood that the frequency ranges mentioned are examples. Any suitable frequency ranges can be used and still fall within the inventive concepts disclosed herein. Different trigger counts can be assigned different colors so that, for example, relatively lower trigger counts produce red, relatively higher trigger counts produce blue, and intermediate trigger counts produce colors in between red and blue. Such a mapping between trigger counts and colors can be smooth (within the limited range of colors supported by the display). In some embodiments, the mapping is linear. In some embodiments, the mapping is non-linear. In some embodiments, the mapping is logarithmic. It will be understood that any suitable mapping between trigger counts and colors, which conveys the trigger frequency information to the user, can be used.

In Figure 2, examples of trigger frequency indicators 235 associated with 10baseT Ethernet packets are displayed toward the left of the trigger display window 110. Examples of trigger frequency indicators 240 associated with USB packets are displayed toward the center of the trigger display window 110. Examples of trigger frequency indicators 245 associated with a 10 kHz periodic signal are displayed toward the right of the trigger display window 110. As can be seen, an operator of the oscilloscope 100 can quickly and efficiently analyze different trigger densities by visually inspecting the trigger frequency indicators that are displayed in the trigger display window 110.

More specifically, the trigger display window 110 is divided into equal time intervals 112. Each of the time intervals 112 is associated with a corresponding logical column (e.g., logical column 255) of the trigger display window 110. For each time interval, a number of trigger events is counted, and thus, a trigger event count (e.g., trigger event count 260) is produced. The trigger event count 260 is written to a memory location (e.g., memory location 250) that is associated with the corresponding logical column (e.g., logical column 255) of the trigger display window 110. The trigger frequency indicator (e.g., 265) is generated based at least on the trigger event count 260. Put differently, each of the trigger frequency indicators represents density information of trigger events occurring within at least one of the time intervals 112.

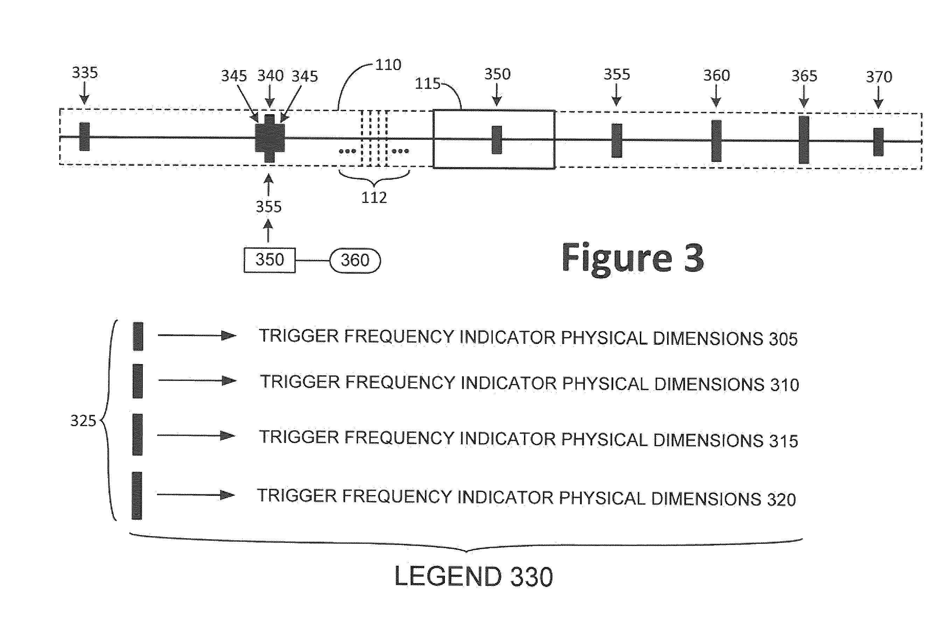

Figure 3 illustrates another example of a trigger display window 110 of the display 140 of Figure 1B. Some of the elements are the same as or similar to those of Figure 2 and a detailed description of such elements is omitted for the sake of brevity. Different physical dimensions of the trigger frequency indicators 325 can be used to indicate the trigger density. The trigger density can be expressed as a physical dimension and assigned to different frequency ranges.

The trigger frequency logic 170 can generate trigger frequency indicators 325, as shown in legend 330, based on the trigger event counts 165 stored in the memory 160. The display 140 can display, within the trigger display window 110, the different trigger frequency indicators 325. Each of the trigger frequency indicators 325 represents density information of trigger events occurring within at least one of the time intervals 112.

In some embodiments, the trigger frequency indicators 325 convey the density information to an operator of the oscilloscope 100 using different physical dimensions of the trigger frequency indicators 325. For example, the trigger frequency indicators 325 can include one or more indicators having first physical dimensions 305 associated with a first trigger frequency range (e.g., from 0 to 300 KHz). By way of another example, the trigger frequency indicators 325 can include one or more indicators having second physical dimensions 310 associated with another trigger frequency range (e.g., from 300 KHz to 1MHz). By way of yet another example, the trigger frequency indicators 325 can include one or more indicators having third physical dimensions 315 associated with yet another trigger frequency range (e.g., from 1MHz to 3MHz). By way of still another example, the trigger frequency indicators 325 can include one or more indicators having fourth physical dimensions 320 associated with still another trigger frequency range (e.g., from 3MHz to 10Mhz or greater).

It will be understood that any suitable physical dimensions capable of distinguishing one frequency range from another can be used. It will also be understood that the frequency ranges mentioned are examples. Any suitable frequency ranges can be used and still fall within the inventive concepts disclosed herein.

In Figure 3, examples of trigger frequency indicators (e.g., 335, 340, 345, 350, 355, 360, 365, and 370) are shown. As can be seen, an operator of the oscilloscope 100 can quickly and efficiently analyze different trigger densities by visually inspecting the physical dimensions of the trigger frequency indicators that are displayed in the trigger display window 110. Although the physical dimensions shown are varied in height or intensity, it will be understood that any suitable differences in the physical dimensions can be used to distinguish between different frequency ranges.

As mentioned above, the trigger display window 110 is divided into equal time intervals 112. Each of the time intervals 112 is associated with a corresponding logical column (e.g., logical column 355) of the trigger display window 110. For each time interval, a number of trigger events is counted, and thus, a trigger event count (e.g., trigger event count 360) is produced. The trigger event count 360 is written to a memory location (e.g., memory location 350) that is associated with the corresponding logical column (e.g., logical column 355) of the trigger display window 110. The trigger frequency indicator (e.g., 340) is generated based at least on the trigger event count 360. Put differently, each of the trigger frequency indicators represents density information of trigger events occurring within at least one of the time intervals 112. As can also be seen, different trigger frequency indicators may be adjacent to each other, such as trigger frequency indicators 340 and 345, depending on the different frequency ranges that are near to each other.

Referring now to both of Figures 2 and 3, the trigger display window 110 looks similar to a scroll bar and it may also serve this function. If the memory 160 is large enough to capture waveform data for the full time of the trigger display window 110, the acquisition process of the oscilloscope can be stopped, and then the position of the main waveform window 105 (of Figure 1B) can be moved by moving the representative window 115 in order to investigate the other trigger events shown in the trigger display window 110.

In some embodiments, waveform data need not be acquired outside of the main waveform window 105, and in such case, the trigger density information can be displayed only with respect to the main waveform window 105 and/or the representative window 115. Although reference is often made herein to the trigger display window 110, such "window" can be the main waveform window 105 instead, or a combination of the trigger display window 110 and the main waveform window 105. Generally, however, the main waveform window 105 displays the signal waveform and is spaced apart from the trigger display window 110. The trigger frequency indicators are preferably displayed within at least the trigger display window 110 and the representative window 115.

When an operator of the oscilloscope 100 adjust the horizontal scale so that the oscilloscope displays a period of time longer than the smallest trigger display window 110, the scale of the trigger display window 110 may change so that it matches or is proportional to the main waveform window 105. When the scale changes, each of the logical display columns represents more or less time. When trigger frequency is indicated (using different colors or different physical dimensions of the trigger frequency indicators), a change in scale need not change the way the frequency is represented. In other words, by default, the colors can stay the same despite the change in scale. Similarly, if different physical dimensions are used, the physical dimensions can stay the same despite the change in scale. Alternatively, in the case where a large total amount of time is represented by the trigger display window 110 (e.g., on the order of a second or more instead of fractions of a second), the corresponding change in time is more pronounced, and so new colors or shades of colors (or new physical dimensions) can be used to reflect the altered scale, and therefore, the altered frequency relative to each time interval.

Alternative to using tick marks to form the trigger frequency indicators, any standard plotting technique can be used such as a line, which is low when the trigger frequency is low and high when the trigger frequency is high. Such a line is similar to the line that is used for representing a waveform on an oscilloscope. That is, waveform lines are low when the voltage is low and high when the voltage is high, typically. Such a trigger frequency plot can be made in the main waveform window 105, in the trigger display window 110, and/or in its own separate window (not shown). Alternatively, or in addition, the trigger frequency plot can include bar graphs, plotting points, points connected with lines, curve fitting, gray scale, colors and/or any combinations thereof.

In the embodiments discussed with reference to Figures 2 and 3, the trigger frequency is displayed as a plot in which time goes from left to right using different colors or some other indication so that the oscilloscope user can see how the trigger circuits view the signal over time. Moreover, more than one trigger event per logical display column can be shown by condensing the trigger frequency information using color or other physical dimension differences between the various trigger frequency indicators, and displaying the condensed trigger frequency information within the resolution limits of the display.

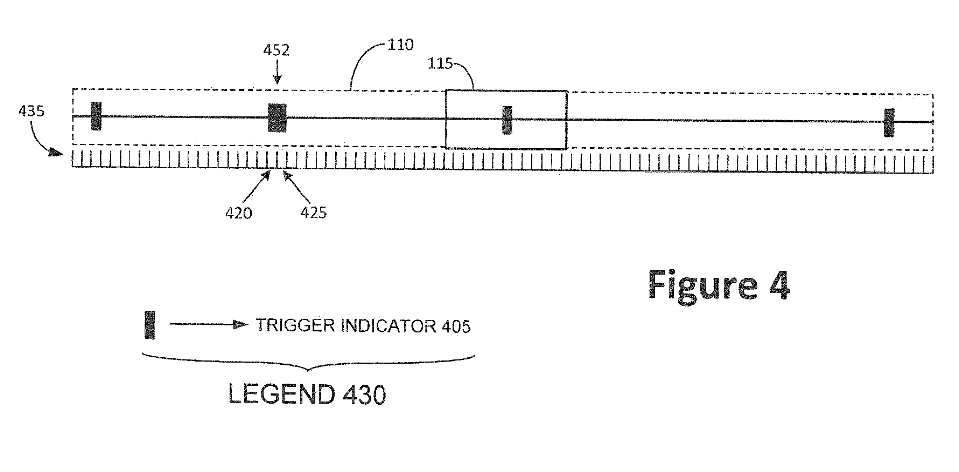

Figure 4 illustrates yet another example of a trigger display window 110 of the display 140 of Figure 1B as it relates to the reduction of jitter. For the sake of simplicity, only one type of trigger indicator 405 is used, as shown by legend 430.

When trigger events arrive at periodic and consistent times, a user would expect the placement of the trigger events within the trigger display window 110 to be stable. Because the equal time intervals 435 are defined before the main waveform trigger has been encountered, the main waveform trigger may fall anywhere within a time interval. Unless compensated for, this will cause periodic trigger events to be displayed with an uncertainty (i.e., jitter) of one time interval. Such jitter, which is otherwise annoying to a user of the oscilloscope, can be reduced or eliminated, or at least made to be less annoying.

One approach for reducing or eliminating the jitter is illustrated in Figure 4, and includes adding some persistence to the display so that when the display is being updated rapidly, the user sees a few frames superimposed. Jitter will therefore show as a wider trigger tick mark (e.g., 452) instead of a tick mark that jitters between two adjacent logical display columns (e.g., 420 and 425).

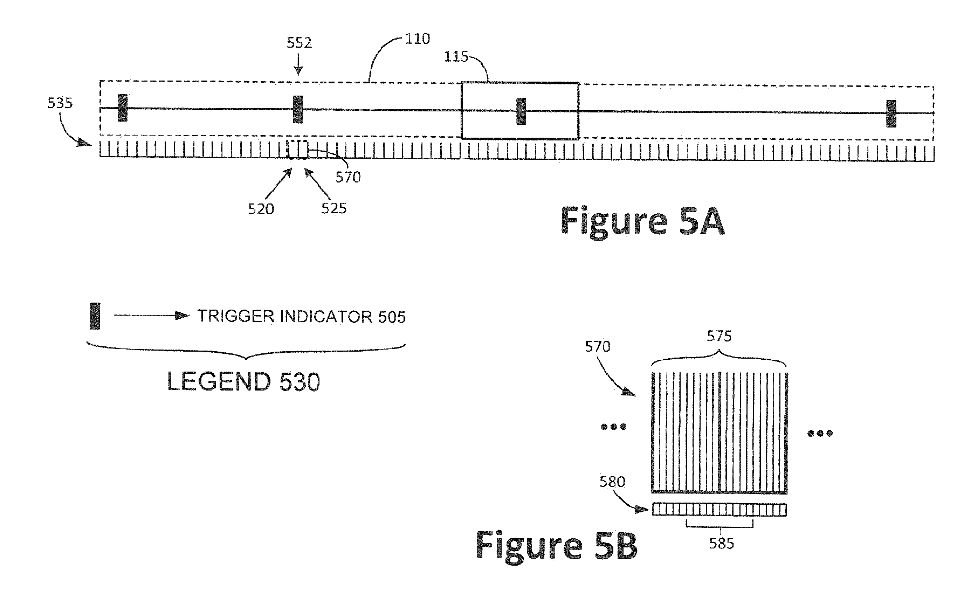

Figures 5A and 5B illustrate still another example of a trigger display window 110 of the display 140 of Figure 1B as it relates to the reduction of jitter. As with Figure 4, for the sake of simplicity, only one type of trigger indicator 505 is used, as shown by legend 530. The trigger display window 110 is divided into equal time intervals 535. Reference is now made to Figures 5A and 5B.

Here, the approach for reducing or eliminating the jitter includes increasing the size of the memory 160 and decreasing the duration of each of the time intervals 535 so that multiple memory locations correspond to each logical display column. For example, as shown in Figure 5B, two of the logical columns 520 and 525, indicated by 570, are shown enlarged for the sake of illustration. The duration of the time intervals are decreased, as shown by the time intervals 575. In other words, each larger time interval is divided into smaller sub-time intervals. In this example, each larger time interval is broken up into 10 sub-time intervals, although any suitable number of sub-time intervals can be used. The trigger frequency indicator 552 can then be shifted to the left or the right by increments of 1/10 (i.e., by one or more of the 10 sub-time intervals). The display 140 can display, within the trigger display window 110, the shifted trigger frequency indicator 552, thereby reducing or eliminating visible jitter.

As can be seen, multiple memory locations 580 are associated with each logical display column. Some memory locations 580 can be associated with multiple logical display columns, or otherwise bridge two different logical display columns. For example, memory locations that bridge display columns, such as memory locations 585, can be assigned to or associated with both columns (e.g., 520 and 525) so that trigger tick marks (i.e., trigger frequency indicators) do not jitter between columns. Instead, any jitter associated with the trigger frequency indicator 552 can be reduced by up to and including 9/10 (assuming 10 sub-time intervals per logical display column) because 9 of the 10 sub-time intervals can each be associated with a single logical display column and only 1 of the 10 sub-time intervals is associated with two logical display columns.

When the number of memory locations is expanded, and the size of each time interval decreased, as shown in Figure 5B, the individual trigger event counts can be stored in each of the pertinent memory locations 580 associated with a given trigger frequency indicator. For example, memory locations 585, which are associated with the trigger frequency indicator 552, can store the trigger event counts for the trigger frequency indicator 552. The trigger event counts associated with memory locations 585 can be summed together and compressed or otherwise used to determine the characteristics of the trigger frequency indicator 552, as shown in the trigger display window 110.

In a broader sense, the resolution of the time intervals and the number of logical display columns need not be related in any particular way. In general, it is preferable to have more time intervals than display columns in order to reduce the jitter shown on the display. By using the inventive techniques disclosed herein, a trigger frequency display is made in the trigger display window in effect having a higher resolution than that of the display itself. Specifically, the resolution of the trigger counts stored in memory can be used. Then, using techniques for displaying an image or indicator with one resolution, on a display having a different resolution, the higher resolution trigger frequency display is fundamentally converted to the resolution of the display and then placed on the display of the instrument.

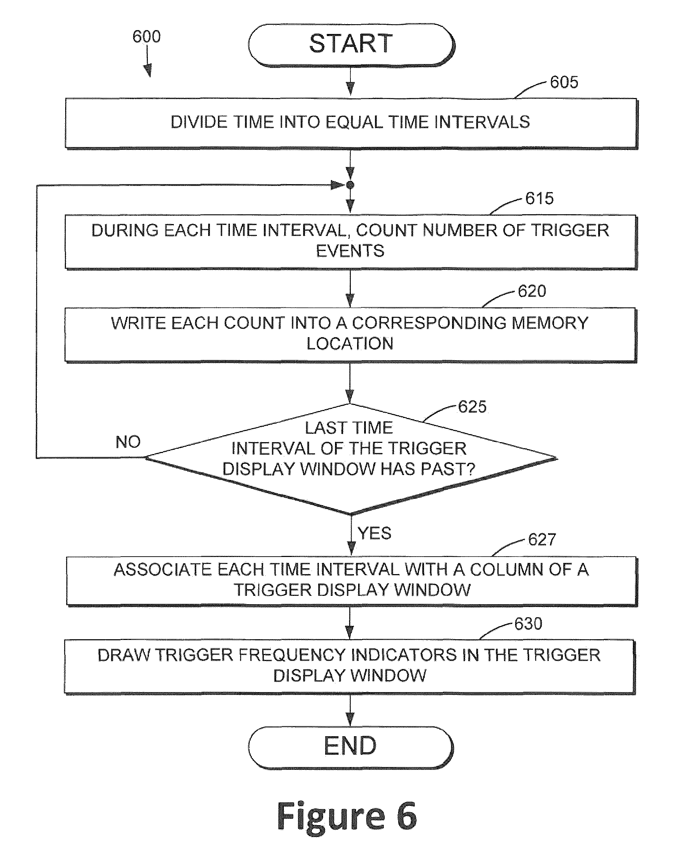

Figure 6 illustrates a flow diagram 600 showing a technique for generating and displaying trigger frequency indicators in accordance with some embodiments of the present invention. The technique begins at 605, where time is divided into equal intervals. During each time interval at 615, the trigger frequency logic 170 (of Figure 1A) counts the number of trigger events. At the end of each time interval, this trigger event count (or a value related to this count) is written into the memory 160. Put differently, each of the counts is stored into a corresponding memory location associated with the particular logical column. As intervals of time pass, consecutive locations in the memory 160 are written with the number of trigger events during each time interval.

The memory 160 can be written circularly until the last time interval of the trigger display window 110 has passed. During these iterations, the oscilloscope may be triggered, and in response to the trigger event, an amount of time before the trigger event (e.g., X seconds before) combined with an amount of time after the trigger event (e.g., X seconds after) can be saved to memory. A determination is made at 625 whether the last time interval of the trigger display window 110 has passed, and if YES, the flow proceeds to 627, where each time interval is associated with a logical column such that each time interval has the duration of one logical column in the trigger display window 110. Having a known column (e.g., associated with the main trigger event such as 125), the other logical columns and time intervals can be aligned relative to the known column. Thereafter, the flow proceeds to 630, where the appropriate frequency trigger indicators are drawn in the trigger display window 110. Otherwise, if NO, meaning the last time interval of the trigger display window 110 has not yet passed, then the flow returns to 615 for further processing.

It should be understood that the elements of the flow diagram 600 in Figure 6 need not occur in the specific order as described, but rather, these elements and determinations can be made at different times and by the same or different hardware instruments or other suitable digital processors. It will also be understood that the steps described in these techniques need not necessarily occur in the order as illustrated or described.

Although the foregoing discussion has focused on particular embodiments, other configurations are contemplated. The following discussion is intended to provide a brief, general description of a suitable machine or machines in which certain aspects of the inventive concept can be implemented. Typically, the machine or machines include a system bus to which is attached processors, memory, e.g., random access memory (RAM), read-only memory (ROM), or other state preserving medium, storage devices, a video interface, and input/output interface ports. The machine or machines can be controlled, at least in part, by input from conventional input devices, such as keyboards, mice, etc., as well as by directives received from another machine, interaction with a virtual reality (VR) environment, biometric feedback, or other input signal. As used herein, the term "machine" is intended to broadly encompass a single machine, a virtual machine, or a system of communicatively coupled machines, virtual machines, or devices operating together. Exemplary machines include computing devices such as personal computers, workstations, servers, portable computers, handheld devices, telephones, tablets, etc., as well as transportation devices, such as private or public transportation, e.g., automobiles, trains, cabs, etc.

The machine or machines can include embedded controllers, such as programmable or non-programmable logic devices or arrays, Application Specific Integrated Circuits (ASICs), embedded computers, smart cards, and the like. The machine or machines can utilize one or more connections to one or more remote machines, such as through a network interface, modem, or other communicative coupling. Machines can be interconnected by way of a physical and/or logical network, such as an intranet, the Internet, local area networks, wide area networks, etc. One skilled in the art will appreciated that network communication can utilize various wired and/or wireless short range or long range carriers and protocols, including radio frequency (RF), satellite, microwave, Institute of Electrical and Electronics Engineers (IEEE) 545.11, Bluetooth^{®}, optical, infrared, cable, laser, etc.

Embodiments of the inventive concept can be described by reference to or in conjunction with associated data including functions, procedures, data structures, application programs, etc. which when accessed by a machine results in the machine performing tasks or defining abstract data types or low-level hardware contexts. Associated data can be stored in, for example, the volatile and/or non-volatile memory, e.g., RAM, ROM, etc., or in other storage devices and their associated storage media, including hard-drives, floppy-disks, optical storage, tapes, flash memory, memory sticks, digital video disks, biological storage, etc. Associated data can be delivered over transmission environments, including the physical and/or logical network, in the form of packets, serial data, parallel data, propagated signals, etc., and can be used in a compressed or encrypted format. Associated data can be used in a distributed environment, and stored locally and/or remotely for machine access. Embodiments of the inventive concept may include a non-transitory machine-readable medium comprising instructions executable by one or more processors, the instructions comprising instructions to perform the elements of the inventive concept as described herein.

Other similar or non-similar modifications can be made without deviating from the intended scope of the inventive concept. Accordingly, the inventive concept is not limited except as by the appended claims.

## Claims

1. A method for displaying trigger frequency on a display of a test and measurement instrument, the method comprising:
dividing, into a plurality of time intervals, time associated with a window of the display of the test and measurement instrument;
during each of the plurality of time intervals, counting a number of trigger events;
associating each of the plurality of time intervals with a corresponding logical column of the window;
producing a plurality of trigger event counts, each trigger event count being associated with a corresponding logical column of the window; and
writing each of the plurality of trigger event counts to a memory location associated with the corresponding logical column of the window.

2. The method of claim 1, further comprising:
generating a plurality of trigger frequency indicators based on the plurality of trigger event counts; and
displaying, within the window, the plurality of trigger frequency indicators.

3. A method for displaying trigger frequency on a display of a test and measurement instrument, the method comprising:
generating a plurality of trigger frequency indicators based on a plurality of trigger event counts; and
displaying, within a window of the display, the plurality of trigger frequency indicators.

4. The method of claim 1 or 3, wherein:
each of the trigger frequency indicators represents density information of trigger events occurring within at least one of the time intervals; and
displaying the plurality of trigger frequency indicators further comprises conveying the density information using different colors of the trigger frequency indicators.

5. The method of claim 4, wherein displaying further comprises:
associating a first color of a first trigger frequency indicator with a first trigger frequency range;
associating a second color of a second trigger frequency indicator with a second trigger frequency range;
displaying, within the window, the first trigger frequency indicator having the first color associated with the first trigger frequency range; and
displaying, within the window, the second trigger frequency indicator having the second color associated with the second trigger frequency range.

6. The method of claim 1 or 3, wherein:
each of the trigger frequency indicators represents density information of trigger events occurring within at least one of the time intervals; and
displaying the plurality of trigger frequency indicators further comprises conveying the density information using different physical dimensions of the trigger frequency indicators.

7. The method of claim 6, wherein displaying further comprises:
associating first physical dimensions of a first trigger frequency indicator with a first trigger frequency range;
associating second physical dimensions of a second trigger frequency indicator with a second trigger frequency range;
displaying, within the window, the first trigger frequency indicator having the first physical dimensions associated with the first trigger frequency range; and
displaying, within the window, the second trigger frequency indicator having the second physical dimensions associated with the second trigger frequency range.

8. The method of any preceding claim, wherein the window is a trigger display window.

9. The method of claim 8, wherein the window is a trigger display window, the method further comprising:
displaying a signal waveform in a main waveform window that is spaced apart from the trigger display window;
displaying a representative window in the trigger display window that represents a position in time of the main waveform window relative to the trigger display window;
generating a plurality of trigger frequency indicators based on the trigger event counts; and
displaying, within at least the trigger display window and the representative window, the plurality of trigger frequency indicators.

10. The method of any of claims 1 to 7, wherein the window is a main waveform window.

11. The method of any preceding claim, further comprising:
in response to a trigger event from among the plurality of trigger events being associated with two logical columns of the window, generating a double-wide trigger frequency indicator having a width of the two logical columns of the window, and displaying, within the window, the double-wide trigger frequency indicator, thereby reducing or eliminating visible jitter.

12. A test and measurement instrument, comprising:
an input configured to receive a signal under test;
a display including a window that is logically divided into a plurality of logical columns, each of the logical columns being associated with one or more time intervals; and
trigger frequency logic configured to generate a count of a number of trigger events associated with the signal under test for each of the one or more time intervals.

13. The test and measurement instrument of claim 12, further comprising:
a memory configured to store each count to a memory location associated with a corresponding logical column from among the plurality of logical columns of the window of the display.

14. The test and measurement instrument of claim 13, further comprising:
a processor coupled to the input and the memory, and associated with the trigger frequency logic,
wherein the processor is configured to associate each of the one or more time intervals with the corresponding logical column of the window of the display, to receive the counts of the number of trigger events for each of the one or more time intervals from the trigger frequency logic, and to transmit the counts to the memory for storage therein.

15. The test and measurement instrument of any of claims 12 to 14, further comprising:
jitter reduction logic associated with the processor and configured to generate a double-wide trigger frequency indicator having a width of two logical columns of the window,
wherein the display is configured to display, within the window, the double-wide trigger frequency indicator, thereby reducing or eliminating visible jitter.

16. The test and measurement instrument of any of claims 12 to 14, wherein the time intervals include a plurality of sub-time intervals, the test and measurement instrument further comprising:
jitter reduction logic associated with the processor and configured to divide each of the logical columns into the plurality of sub-time intervals and to shift a trigger frequency indicator by an increment of at least one of the sub-time intervals,
wherein the display is configured to display, within the window, the shifted trigger frequency indicator, thereby reducing or eliminating visible jitter.
